(19) Europäisches Patentamt / European Patent Office / Office européen des brevets

(11) **EP 2 272 928 A1**

(12) **EUROPÄISCHE PATENTANMELDUNG**

(43) Veröffentlichungstag:
**12.01.2011 Patentblatt 2011/02**

(51) Int Cl.:
***C09D 183/04*** (2006.01)  ***C08J 7/04*** (2006.01)
***H01L 51/52*** (2006.01)

(21) Anmeldenummer: **09163519.3**

(22) Anmeldetag: **23.06.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**
Benannte Erstreckungsstaaten:
**AL BA RS**

(71) Anmelder: **Fraunhofer-Gesellschaft zur Förderung der angewandten Forschung e.V.**
**80686 München (DE)**

(72) Erfinder:
• **Amberg-Schwab, Sabine**
**97250 Erlabrunn (DE)**

• **Noller, Klaus**
**84184 Tiefenbach (DE)**
• **Weber, Ulrike**
**97295 Waldbrunn (DE)**
• **Miesbauer, Oliver**
**85276 Pfaffenhofen (DE)**

(74) Vertreter: **Leonhard, Frank Reimund et al**
**Leonhard - Olgemöller - Fricke Patentanwälte**
**Postfach 10 09 62**
**80083 München (DE)**

(54) **Hochbarrierenverbunde und Verfahren zu ihrer Herstellung**

(57) Die Erfindung betrifft einen Hochbarriereverbund, umfassend ein Substrat, eine erste Schicht aus einem ausschließlich anorganischen Material, eine erste Schicht aus einem anorganisch-organischen Hybridmaterial und eine zweite Schicht aus einem ausschließlich anorganischen Material, **dadurch gekennzeichnet, dass** die Schicht aus anorganisch-organischem Hybridmaterial unmittelbar zwischen den beiden Schichten aus ausschließlich anorganischem Material angeordnet ist und eine Dicke von unter 1 μm aufweist. Der Verbund lässt sich mit Hilfe der Schritte herstellen, dass die Schicht oder Schichten aus anorganisch-organischem Hybridmaterial durch den Auftrag eines Lackmaterials mit einer Viskosität von 0,002 bis 0,02 Pas und/oder einer Oberflächenspannung im Bereich von 25 bis 35 mN/m oder eines Kaschiermaterials mit einer Viskosität von 0,1 bis 200 Pas auf dem mit anorganischem Material beschichtetem aufgebracht wird/werden, wobei der Transport des Substrats ohne den Kontakt zu den Transport bewirkenden Mitteln erfolgt.

**Figur 2**

## Beschreibung

Die Erfindung betrifft Mehrfachschichtsysteme auf flexiblen oder starren Substraten mit extrem hohen Barriereeigenschaften gegenüber der Permeation von Wasserdampf, Sauerstoff und migrierfähigen Monomeren. Die Mehrfachschichtsysteme sind aus mindestens zwei anorganischen Schichten (z. B. Sputterschichten) und einer zwischenliegenden anorganisch-organischen Hybridpolymer-Schicht aufgebaut, die einen Durchmesser von unter 1 $\mu$m besitzt.

Als flexible Verpackungslösung für empfindliche Lebensmittel stehen heute Polymerfolien zur Verfügung, die in Verbindung mit einer im Vakuum aufgedampften Schicht aus Al, $AlO_x$ oder $SiO_x$ so niedrige Durchlässigkeiten gegenüber Sauerstoff und Wasserdampf aufweisen, dass diese Lebensmittel innerhalb der Haltbarkeitsdauer vor Oxidation, Feuchteeinwirkung oder -verlust geschützt werden können. Aufdampfschichten werden in großen Mengen industriell gefertigt und stehen zu günstigen Preisen zur Verfügung. In Abhängigkeit der Folienqualität und der jeweiligen anorganischen Schicht erreichen sie (bezogen auf eine 12 $\mu$m PET-Folie mit einer anorganischen Schicht) Durchlässigkeiten bis unter 1 $cm^3/m^2d$ bar ($O_2$) und 0,5 $g/m^2d$ ($H_2O$).

Für technische Anwendungen mit hohen Anforderungen an die Barriereeigenschaften (Verkapselungsfolien für OLEDs und organische Solarzellen) reichen diese Folienverbunde nicht aus. Beim gegenwärtigen Stand der Technik ist die Verbesserung der Barriere mit anorganischen Einzelschichten durch Defekte limitiert. Daher ist man für den Anwendungsbereich der Ultrabarrierefolien dazu übergegangen, Mehrschichtaufbauten zu entwickeln: anorganische Barriereschichten, appliziert durch PVD-Verfahren, werden mit ausgleichenden, meist organischen Zwischenschichten kombiniert, die die Oberflächen glätten, Wachstumsdefekte in darunter liegenden Schichten abdecken und die Flexibilität des gesamten Schichtaufbaus garantieren. US 6,570,325 B2 schlägt als Material für diese Zwischenschichten eine Palette von Polymersystemen vor, die auf den ersten Blick wohl fast alle Monomeren und Prepolymeren umfasst, die sich überhaupt zum schichtförmigen Auftrag und zur nachträglichen Vernetzung eignen könnten. Der Schwerpunkt liegt auf Vakuum-Auftragsverfahren; es werden jedoch auch Materialien genannt, die als flüssige Phase auf der jeweiligen Unterlage aufgebracht werden. Die Schichtdicke wird als beliebig auswählbar angegeben, wobei ein konkret genannter Dickenbereich, nämlich 1000-10000 Å wohl in Hinblick auf aus der Gasphase aufzubringende Materialien genannt ist. Mit den angegebenen Flüssigauftragverfahren lassen sich ohne die Erkenntnisse der vorliegenden Erfindung, nämlich im angestrebten Rolle-zu-Rolle-Verfahren, solch dünne Schichten zumindest nicht als Entkopplerschichten realisieren: Während das Spin-Coating sich für die Herstellung von Rollen überhaupt nicht eignet, erhält man mit Sprühverfahren unebene Oberflächen.

Weitere Barrierefolien sind in WO08/122292, US 2006/0063015, US 2008/196664, US 2008/305359, US 7,442,428, US 2008/167413, US 7,449,246, US 2007/224393, US 2008/237615, EP 1384571 B1 und EP 1563989 offenbart.

Aus EP 1975214 A1 ist ein Verfahren zum Ausbilden dünner flüssiger Schichten auf flexiblen Substraten aus Polymeren und/oder Metallen bekannt.

In der Praxis werden für die Zwischenschichten meist Acrylate verwendet. Da diese Schichten nur eine unzureichende Barriere darstellen, müssen heute ca. 5 Schichtpaare verwendet werden, um eine Verringerung der Permeation um mehrere Größenordnungen zu erreichen. Kommerziell bietet solche Systeme weltweit vor allem die Firma Vitex Systems, USA an, siehe Affinito, J., Hilliard, D.: "A New Class of Ultra-Barrier Materials", Proc. 47th Anspruch. Tech. Conf., Dallas, April 2004, Society of Vacuum Coaters, Albuquerque (2004), S. 563-593.

Ein anderes Konzept verfolgt die Firma General Atomics, die einen Rolle-zu-Rolle Prozess für die Beschichtung von flexiblen PC-Folien mit Aluminiumoxid (ca. 80 nm) entwickelt hat. Durch eine einzige Beschichtung sollen Wasserdampf-Barrierewerte von $10^{-4}$ $g/m^2d$ zugänglich sein. Ein Kalziumspiegeltest zeigt einen Abbau der Calciumschicht auf die halbe Fläche bei 85°C und 85% Luftfeuchte nach ca. 200 h. Dabei werden diese Barriereschichten auf der Außenseite des Trägermaterials der OLED aufgebracht und die OLED wieder mit einer 80 nm dicken Schicht Aluminiumoxid versehen (siehe http://displayproducts.ga.com/pdf/High%20Performance%20Barrier.pdf).

Seit vielen Jahren ist es bekannt, dass die Sperreigenschaften von mit Metallen oder Keramiken, z.B. Metalloxiden beschichteten Polymerfolien durch das zusätzliche Aufbringen einer anorganisch-organischen Hybridpolymerschicht drastisch verbessert werden kann. Anorganisch-organische Hybridpolymere, die Siliciumatome enthalten, werden auch als organisch modifizierte Kieselsäurepolykondensate bezeichnet; sie lassen sich über das sogenannte Sol-Gel-Verfahren aufbauen und weisen ein in der Regel durch hydrolytische Kondensation entsprechender Silane gebildetes, anorganisches Netzwerk sowie organische Substituenten und gegebenenfalls Heteroatome im anorganischen Netzwerk auf. Die organischen Substituenten können ggf. ein weiteres, organisch verknüpftes, das anorganische Netzwerk interpenetrierendes Netzwerk bilden, das durch Polymerisation von organisch polymerisierbaren Substituenten an den oder einem Teil der Siliciumatome, ggf. in Gegenwart copolymerisierbarer rein organischer Komponenten, entstanden ist. Diese Materialien sind unter dem Markennamen ORMOCER®e, eingetragen für die Anmelderin der vorliegenden Erfindung, in weitem Umfang bekannt geworden. Verpackungsmaterialien mit derartigen Sperrschicht-Kombinationen sind aus DE 19659286 C2 oder EP 802218 B1 bekannt. Dabei werden die Barriereschichten in der Regel als Nasslack aufgetragen und besitzen eine Dicke von 1 bis 15 $\mu$m.

Für eine Reihe von Anwendungen, z. B: die flexible Verkapselung von OLEDs und Solarzellen, werden extreme Barrieren gegenüber den in der natürlichen Umgebung vorhandenen Gasen wie Sauerstoff und gegenüber Luftfeuchtigkeit benötigt. Wie ebenfalls oben erwähnt, lassen sich derartige Barrieren nur durch Mehrfach-Schichtaufbauten realisieren, was außerordentlich kostenintensiv ist.

Aufgabe der vorliegenden Erfindung ist es, als Ultrabarrieren geeignete Schichtverbunde bereitzustellen, die mit einer geringen Anzahl von Schichten extrem geringe Wasserdampfdurchlässigkeiten und vorzugsweise auch sehr geringe Sauerstoffdurchlässigkeiten aufweisen.

Die Erfinder der vorliegenden Erfindung haben mehrere Effekte beobachtet, aus denen sie das unerwartete Ergebnis ableiten konnten, dass besonders gute Sperreigenschaften nicht mit deutlich dickeren Zwischenschichten erhalten werden und dass es zum Erhalt von Hochbarriereverbunden nicht notwendig ist, eine große Zahl von Schichten übereinander zu packen. Ganz im Gegenteil: Bereits sehr gute Sperreigenschaften lassen sich durch einen Barriereverbund erzielen, der aus einer Kombination des jeweiligen Substrats mit mindestens einer, bevorzugt zwei anorganischen Sperrschichten und mindestens einer anorganisch-organischen hybridpolymeren Zwischenschicht besteht, die sehr dünn, d.h. mit einer Dicke von unter 1 $\mu$m, vorzugsweise von unter 500 nm und besonders bevorzugt von weniger als 200 nm oder sogar weniger als 100 nm, auf das jeweilige Substrat bzw. die darunter liegende anorganische Sperrschicht aufgetragen ist, wenn diese als gut dichtende Schicht ausgebildet ist. Diese Erkenntnis konnte nur deshalb gewonnen werden, weil die Erfinder erstmalig ein Verfahren bereitstellen, das das gleichmäßige Auftragen solch dünner Hybridpolymer-Schichten ermöglicht. Bisher konnte dies, insbesondere für kontinuierliche Verfahren wie das Rolle-zu-Rolle Verfahren, nicht realisiert werden.

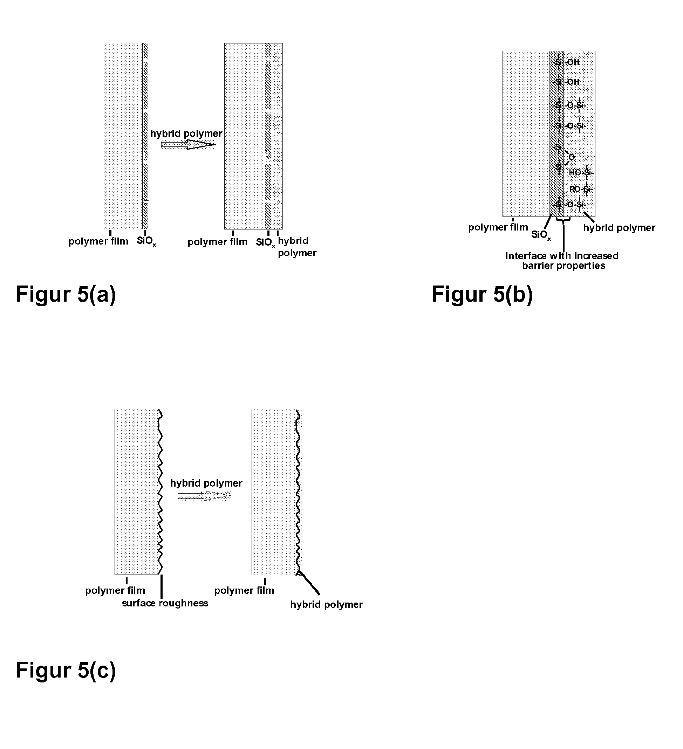

In Figur 5 sind die vorteilhaften Eigenschaften, die bereits bei Barriereverbundfolien aus nur einem auf das Substrat aufgetragenen Schichtpaar aus anorganischer Barriereschicht und anorganisch-organischer Hybridpolymerschicht auftreten, im Prinzip dargestellt. Figur (a) zeigt, dass das Aufbringen einer Nasslackschicht aus anorganisch-organischem Hybridpolymer-Material auf eine anorganische Sperrschicht (hier im Beispiel aus SiO$_x$) deren Fehlstellen oder Pinholes abdeckt und ausgleicht. Die makroskopischen Defekte werden dadurch teilweise kompensiert. Dieser Effekt ist aus dem Stand der Technik bereits bekannt. Figur (b) zeigt schematisch die gute Haftung einer Si-O-haltigen anorganisch-organischen Polymerschicht auf einer Siliciumoxidschicht aufgrund der sich an der Grenzfläche ausbildenden Si-O-Si-Bindungen. Dieses Prinzip gilt auch für andere Metalloxide, da auch andere M-O-M oder Si-O-M-Bindungen denselben Effekt haben; er konnte von den Erfindern an einem Schichtaufbau mit einer Aluminiumoxidschicht, die an eine anorganisch-organische, Siliciumatome enthaltende Hybridschicht grenzt, mittlerweile experimentell bestätigt werden. Auch bei reinen Metallschichten als anorganischen Schichten kann man diesen Effekt beobachten, weil die Metalle auf ihrer Oberfläche ebenfalls Hydroxygruppen ausbilden. Von besonderer Bedeutung ist es, dass die Hybridpolymerschichten bei Einsatz geringviskoser Lacke mit einer sehr geringen Rauigkeit (< 0,5 nm) ausgebildet werden können, was es erlaubt, eine defektarme anorganische Schicht darauf aufzutragen. Aus diesem Grund kann eine Hybridpolymerschicht auch dazu angewendet werden, eine raue Oberfläche zu planarisieren. Dies ist von besonderem Interesse für manche organische Substrate, da viele organische Folien eine extrem raue Oberfläche besitzen.

Zusammenfassend lässt sich sagen, dass es den Erfindern gelungen ist, Hybridpolymerschichten mit sehr guter Schichthaftung auf anorganischen Schichten sowie sehr glatten Oberflächen bereitzustellen, die zur unten beschriebenenen Barrierewirkung beitragen. Diese Schichten werden durch den Auftrag von Lacken bzw. Kaschierklebern mit ausgezeichneten Fließeigenschaften hergestellt. Wegen der niedrigen Viskositäten der Lacke ist es denkbar, dass die Lacke, evtl. unter dem Einfluss der Kapillarwirkung, in die Defekte der darunter liegenden anorganischen Schicht hineinfließen. Diese Defektfüllung führt zu einer zusätzlichen Barrierewirkung der betrachteten Barrierefolien.

Ausgehend von diesen Erkenntnissen wird die Aufgabe der Erfindung vorzugsweise durch die Bereitstellung von Schichtverbünden gelöst, in denen eine anorganisch-organische Hybridschicht beidseitig von je einer rein anorganischen Sperrschicht umgeben ist. Die Sperreigenschaften sind in diesen Schichtverbünden im Vergleich zu denjenigen aus einer Hybridschicht in Kombination mit nur einer anorganischen Schicht nochmals wesentlich besser.

Die Erfinder haben weiterhin mit numerischen Berechnungen zeigen können, dass sich die Barrierewirkung eines solchen Systems gegenüber permeierendem Sauerstoff - und etwas schwächer auch gegenüber permeierendem Wasserdampf -, deutlich verbessern lässt, wenn die Dicke der Hybridschicht reduziert wird. Dieser völlig überraschende Effekt lässt sich wahrscheinlich folgendermaßen erklären.

Die Permeation eines Gases durch eine Barriere oder ein Substrat, beispielsweise eine Kunststofffolie mit einer bestimmten Durchlässigkeit für Permanentgase aus einem Raum mit höherer Konzentration dieses Gases in einen Raum mit geringerer Konzentration des Gases, wird bestimmt durch die Adsorption dieses Gase an der Oberfläche der Folie, dessen Absorption im Folienmaterial, die Diffusion durch das Folienmaterial und die Desorption vom Folienmaterial in den zweiten Raum hinein. Die treibende Kraft für die Permeation ist die Partialdruckdifferenz des Gases zwischen diesen beiden Räumen. Die Durchlässigkeit einer homogenen Polymerfolie für das Gas lässt sich durch den Permeationskoeffizienten P beschreiben. Dieser ist das Produkt aus dem Löslichkeitskoeffizienten S des Gases im Polymer und dem Diffusionskoeffizienten D. Er ist unabhängig von der Dicke der Folie. Die Durchlässigkeit Q der Folie ergibt sich dann als Q = P/d (d = Dicke des Substrats). Die Folie kann als Widerstand betrachtet werden. Werden zwei solcher Folien oder Schichten hintereinander geschaltet, so folgt die Gesamtdurchlässigkeit Q der Kirchhoffschen Regel, d.h. $1/Q = 1/Q_1 + 1/Q_2$, wobei $Q_1$ und $Q_2$ die Durchlässigkeiten der beiden Schichten sind. Daraus lässt sich entnehmen, dass die Schicht mit der niedrigsten Durchlässigkeit die größte Wirkung für den Verbund besitzt.

Rein anorganische Barriereschichten, wie Schichten aus Metallen oder Metalloxiden, die aus der Gasphasen aufgebracht (aufgedampft) werden, sind theoretisch völlig gasdicht, auch wenn sie sehr dünn sind. In der Praxis stimmt dies jedoch nicht, denn die aufgebrachten Schichten weisen Fehlstellen bzw. Defekte auf, durch die Gase permeieren können. Die Dichtigkeit der anorganischen Barriereschicht lässt sich nicht beliebig durch eine Steigerung der Dicke des Materials steigern und nimmt ab einer bestimmten Dicke sogar wieder ab. Die Barriereverbesserung, die durch das Aufbringen einer solchen Schicht auf ein Polymer erzielt wird, wird mit BIF (barrier improvement factor; Durchlässigkeit des bedampften Polymers geteilt durch die Durchlässigkeit des unbedampften Polymers) bezeichnet. Für die Durchlässigkeit Q eines Verbunds Polymer/anorganische Barrierschicht/ Substratpolymer gilt $1/Q = BIF(1/Q_1 + 1/Q_2)$, wobei $Q_1$ und $Q_2$ die Durchlässigkeiten des unbedampften Substratpolymer bzw. des unbedampften Hybridpolymers sind. Das bedeutet, dass der BIF auf die Hybridpolymerschicht genauso wie auf das Substratpolymer wirkt. Da wie erwähnt die Bedampfungsschichten aufgrund von Defekten nicht absolut dicht sind, hängt deren tatsächliche Dichtigkeit u.a. von der Oberflächenplanarisierung der darunter liegenden Schicht ab. Die Barrierewirkung einer nicht rein anorganischen, d.h. polymeren oder hybridpolymeren Schicht, die sich im Kontakt mit genau einer anorganischen Schicht befindet, steigt mit ihrer Schichtdicke. Ab einer kritischen Schichtdicke erhält man jedoch keine deutlichen Steigerungsraten mehr.

Überraschenderweise gilt dieses Verhalten jedoch nicht für eine anorganisch-organische Hybridpolymerschicht, wie sie von den Erfindern bereitgestellt werden kann, zwischen zwei rein anorganischen Barriereschichten. Bei der Permeation eines Gases, z.B. $O_2$, durch einen solchen Multilayer dringen die Gasmoleküle durch einen Defekt der einen anorganischen Schicht in die Hybridpolymerschicht ein, wandern in dieser im wesentlichen parallel zur Schichtoberfläche zu einem Defekt der zweiten anorganischen Schicht, und verlassen die Hybridpolymerschicht durch diesen Defekt. Da die Durchlässigkeit der Hybridpolymerschicht parallel zur Schichtoberfläche näherungsweise proportional zur Querschnittsfläche für diese Diffusion, d.h. näherungsweise proportional zur Dicke der Hybridpolymerschicht ist, lässt sich die Barrierewirkung des Multilayers durch Verringerung dieser Dicke deutlich vergrößern. Mit anderen Worten: Es kommt nicht auf die Länge des Weges von der Eintrittsoberfläche eines Gasmoleküls zum nächstgelegenen Punkt auf der gegenüberliegenden Seite an, sondern auf die Querschnittsfläche, die sich den Gasmolekülen als Eintrittsfläche für die Diffusion entlang der Schichtfläche anbietet. Je geringer das Volumen der Schicht ist, desto weniger Gasmoleküle können pro Zeiteinheit hindurch diffundieren. Bei zweidimensionalen Schichtgebilden ist verständlich, dass die Dicke der Schicht dieses Volumen bestimmt. Daher wird die Diffusionsbarriere umso höher, je weniger Material die anorganischorganische Barriereschicht aufweist, d.h. je dünner sie ist.

Voraussetzung für diesen als Tortuous Path-Effekt bezeichneten Effekt ist die Versetzung der Defekte der zweiten anorganischen Schicht gegenüber den Defekten der ersten anorganischen Schicht. Dies wird durch die Zwischenschicht erreicht, da diese die Defekte der ersten anorganischen Schicht abdeckt und somit eine Entkopplung der Defekte der beiden anorganischen Schichten bewirkt. Neben diesem Effekt spielt natürlich der oben bereits erwähnte, bekannte Entkopplungseffekt eine Rolle. Aber auch dieser Entkopplungseffekt wird von den erfindungsgemäß bereitgestellten Barriereverbünden verstärkt. Als Faustregel kann nämlich gelten, dass die Dicke der polymeren Zwischenschichten vorzugsweise nicht größer (und stärker bevorzugt deutlich kleiner) ist als der halbe Durchmesser der Defekte oder Pinholes in den anorganischen Schichten.

Den Erfindern ist es gelungen, Beschichtungslacke bzw. Kaschiermassen mit ausgezeichneten Fließeigenschaften bereitzustellen, die solche Viskositäten besitzen, dass sie in der Lage sind, aufgrund der großen Oberflächen in den Defekten und der daraus resultierenden Kapillarwirkung in diese hineinzufließen ("gesaugt" zu werden). Dadurch entsteht eine wirksamere Entkopplung dieser Defekte, die die Barrierewirkung extrem verbessert.

Insgesamt hängt die Durchlässigkeit Q* des Grundelements anorganische Schicht / Hybridpolymerschicht / anorganische Schicht der erfindungsgemäßen Barrierefolien auf komplexe Art ab von folgenden Größen:

- der Größe und Häufigkeit der Defekte in beiden anorganischen Schichten,
- dem mittleren Abstand zwischen einem Defekt der einen und dem nächsten Defekt der anderen anorganischen Schicht
- der Dicke der hybrid polymeren Zwischenschicht und
- der normierten Durchlässigkeit $Q_{100}$ der hybridpolymeren Zwischenschicht als Skalierungsgröße.
- Falls die Defekte der anorganischen Schicht gefüllt sind, hängt die Durchlässigkeit Q* auch von der Dicke der anorganischen Schicht ab.

Diese Abhängigkeiten von Q* wurden durch numerische Simulationen untersucht [O. Miesbauer, M. Schmidt, H.-C. Langowski, Stofftransport durch Schichtsysteme aus Polymeren und dünnen anorganischen Schichten, Vakuum in Forschung und Praxis, 20 (2008) Nr. 6, 32-40.].

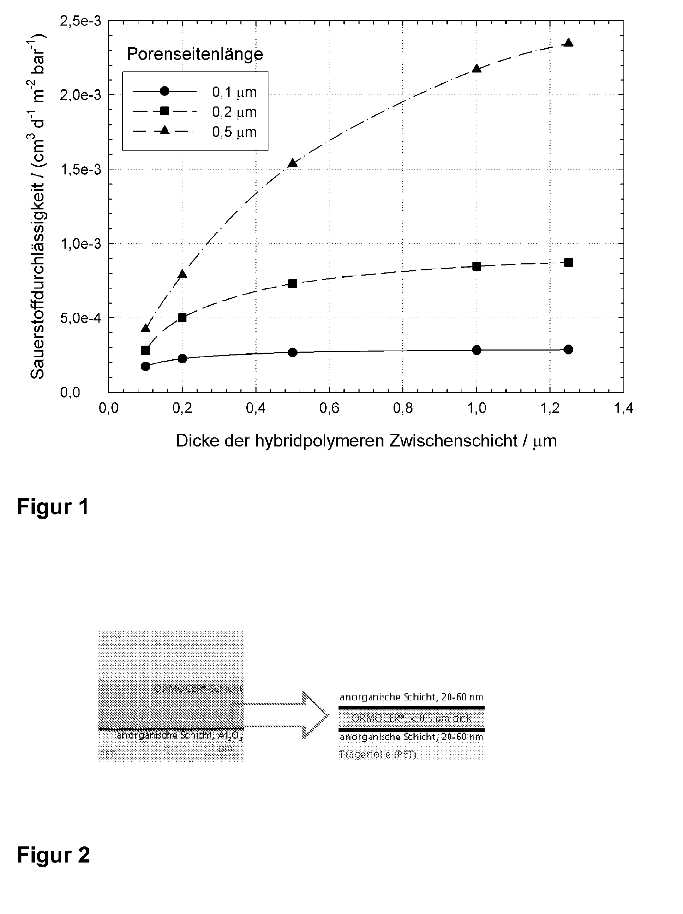

In Figur 1 ist die Sauerstoffdurchlässigkeit der Struktur Anorganische Schicht / Hybridpolymere Zwischenschicht / Anorganischen Schicht als Funktion der Dicke der Zwischenschicht für unterschiedliche Defektgrößen und für einen Porenabstand ≈ 94 μm gezeigt. Dabei sind die Poren in den beiden anorganischen Schichten leer, periodisch verteilt und gegeneinander verschoben. Man erkennt, dass eine Reduzierung der Dicke der Zwischenschicht zunächst zu keiner wesentlichen Verringerung der Durchlässigkeit führt. Erst wenn diese Dicke klein genug ist, wird die Durchlässigkeit bei weiterer Reduzierung der Dicke verringert. Die Schichtdicke, unterhalb derer die Durchlässigkeit mit fallender Dicke verringert wird, steigt mit wachsender Defektgröße.

Allerdings ergeben sich für weitere Schichtfolgen dieser Art wieder einfachere Zusammenhänge: Die Verdopplung des Grundelements durch eine 5-Schicht-Struktur mit der Schichtfolge anorganische Schicht - erste hybridpolymere Zwischenschicht - anorganische Schicht - zweite hybridpolymere Zwischenschicht - anorganische Schicht liefert für den Fall, dass die beiden polymeren Schichten und die drei anorganischen Schichten jeweils identisch sind:

$$Q_{ges}^{-1} = Q^{*-1} + Q^{*-1}$$

oder

$$Q_{ges} = 0,5 \; Q^*$$

Damit erhält die erste Sandwichstruktur die größte Bedeutung für die Barriereeigenschaften des fertigen Schichtsystems, da sie die Barriereeigenschaften der Basisfolie um viele Zehnerpotenzen verbessern kann, die nächste Schichtfolge aus einer weiteren anorganisch-organischen Hybridschicht und einer weiteren anorganischen Schicht jedoch nur noch um den Faktor 2. Dies gilt analog für weitere Schichtpaare in alternierenden Schichtsystemen aus anorganischen und hybridpolymeren Schichten.

Für die Herstellung von Hoch- bzw. Ultrabarrieren ergeben sich daraus folgende Konsequenzen:

■ Wie bei den oben betrachteten Schichtsystemen auch ist die Herstellung anorganischer Schichten mit möglichst niedrigen Defekthäufigkeiten und möglichst hohen Defektabständen wichtig. Solche Schichten lassen sich mit den im Stand der Technik bekannten Maßnahmen realisieren.
■ Für die hybridpolymeren Zwischenschichten sollten Materialien mit möglichst niedrigen normierten Durchlässigkeiten für Wasserdampf und Sauerstoff ($Q_{100}$) eingesetzt werden.
■ Die anorganisch-organischen, hybridpolymeren Zwischenschichten müssen in möglichst geringen Dicken (vorzugsweise ≤ 100 nm) aufgetragen werden. Dabei muss allerdings die erreichte Oberflächenqualität hoch sein, insbesondere dürfen die Defekte auf der Unterlage nicht durch eine zu dünne oder schlecht verlaufende Schicht auf deren Oberfläche abgebildet werden.

Aufgrund der oben dargelegten Betrachtungen von Sandwich-Systemen über die Anordnung eines Verbunds aus anorganischen und hybridpolymeren Schichten auf einem Substrat ergeben sich weitere bevorzugte Ausführungsformen der Erfindung mit den folgenden ungefähren, auf Basis von $SiO_x$ beobachteten Verbesserungen der Barrierwirkung:

Tabelle 1

| Einflusst | Faktor zur Verringerung der Sauerstoffdurchlässigkeit |
|---|---|
| Zweites Paar $SiO_x$ / Hybridpolymer | ≈ 2 |
| Verringerung der Dicke der Hybridpolymer-Schicht von 1,5 μm auf | |
| 300 nm | < 2 |
| 100 nm | 2 |
| 20 bis 30 nm | 10 |

(fortgesetzt)

| Einflusst | Faktor zur Verringerung der Sauerstoffdurchlässigkeit |
|---|---|
| Verringerung der mittleren Defektgröße | ☞  Barrierewirkung in Defekten dominiert $\Rightarrow$ Q $\approx$ (Porengröße)$^2$<br><br>☞  Barrierewirkung in Zwischenschicht dominiert: siehe **Figur 1** |
| Vergrößerung des mittleren Defektabstandes | ☞  Barrierewirkung in Defekten dominiert $\Rightarrow$ Q $\approx$ 1/ (Porengröße)$^2$ |
| Vergrößerung der Dicke der SiO$_x$-Schicht | ☞  Barrierewirung in Defekten dominiert $\Rightarrow$ Q $\approx$ 1/Dicke<br><br>☞  Barrierewirkung in Zwischenschicht dominiert: siehe **Figur 1** |
| Verringerung des Permeationskoeffizienten von Hybridpolymer | Q $\approx$ Permeationskoeffizient |

Aus Tabelle 1 lässt sich entnehmen, dass eine Sauerstoffdurchlässigkeit von $10^{-3}$ cm$^3$/(d·m$^2$·bar) für die erfindungsgemäßen Zweischichtbarrieren gemäß der Erfindung erreichbar sind. Realistisch betrachtet ist dies ein Faktor von ca. 10 gegenüber den bisher im Stand der Technik erreichbaren Werten.

Weitere Barriereverbesserungen um um mehrere Größenordnungen können erreicht werden durch eine oder mehrere der nachfolgend aufgelisteten Maßnahmen:

- Weitere Verringerung der Dicke der anorganisch-organischen Hybridpolymer-Schicht (unter der Voraussetzung, dass diese weiterhin geschlossen ist)
- Verringerung der Porosität der anorganischen Schicht
- Verringerung des Permeationskoeffizienten der anorganisch-organischen Hybridpolymer-Schicht
- Auftrag der anorganisch-organischen Hybridpolymer-Schicht unter Reinraumbedingungen, Reinigung der Folie vor Auftrag der einzelnen Schichten.

Die anorganisch-organischen Hybridpolymere der vorliegenden Erfindung werden unter Verwendung mindestens eines Silans der Formel (I)

$$R^1{}_aR^2{}_bSiX_{4-a-b} \qquad (I)$$

hergestellt, worin R$^1$ ein Rest ist, der einer organischen Vernetzung/Polymerisation zugänglich ist, R$^2$ ein (zumindest vorwiegend) organischer Rest ist, der keiner organischen Vernetzung/Polymerisation zugänglich ist und X eine OH-Gruppe oder eine Gruppe bezeichnet, die unter Hydrolysebedingungen eine Kondensationsreaktion mit weiteren solchen Gruppen eingehen kann und damit zumindest teilweise durch die Anbindung an ein Sauerstoffatom einer weiteren Siliciumverbindung der Formel (I) oder einer anderen hydrolytisch kondensierbaren Siliciumverbindung oder einer vergleichbaren Verbindung eines Metalls zur anorganischen Vernetzung während der Sol-Gel-Bildung beiträgt. a und b können 0, 1 oder gegebenenfalls auch 2 sein, 4-a-b kann in seltenen Fällen 1 sein, ist aber in der Regel 2 oder 3.

Die Reste X werden als anorganische Netzwerkbildner bezeichnet. Die Reste R$^1$ werden auch als organische Netzwerkbildner bezeichnet, da sie zusätzlich zu dem anorganischen, durch hydrolytische Kondensation gebildeten Netzwerk die Ausbildung eines organischen Netzwerks ermöglichen. Die Reste R$^2$ werden als organische Netzwerkwandler bezeichnet, da sie die Eigenschaften des Hybridpolymeren mitbestimmen, ohne in das oder die Netzwerke eingebaut zu werden.

X kann insbesondere ein Alkoxy, Wasserstoff, Hydroxy, Acyloxy, Alkylcarbonyl, Alkoxycarbonyl und, in spezifischen Fällen, auch eine primäre oder sekundäre Aminogruppe sein. Vorzugsweise ist X eine Alkoxygruppe, ganz besonders bevorzugt eine C$_1$-C$_4$-Alkoxygruppe. 4-a-b = 3 ist besonders bevorzugt.

Die Hybridpolymere können gegebenenfalls weiterhin unter Verwendung von (Halb-) Metallalkoxiden hergestellt werden, die z.B. unter Bor-, Aluminium-, Zirkon-, Germanium- oder Titanverbindungen, aber auch unter anderen löslichen, vorzugsweise Alkoxide bildenden Haupt- und Übergangsmetallverbindungen ausgewählt sein können.

Die Ausgestaltung der Erfindung, worin 4-a-b = 3 ist, ist deshalb besonders bevorzugt, weil das eingesetzte Silan $R^1SiX_3$ drei anorganische Vernetzungsstellen aufweist, die bei der nachfolgenden Hydrolyse zu einem hohen Vernetzungsgrad führen. Damit werden die Schichten dichter und glasähnlicher und besitzen somit eine höhere intrinsische Barrierewirkung. Dementsprechend sind Hybridpolymere bevorzugt, die ausschließlich derartige Silane enthalten.

Aus vergleichbaren Gründen kann es stattdessen bevorzugt sein, ein Silan der Formel (I) (oder eine Kombination mehrerer solcher Silane) zusammen mit einem Silan der Formel $SiX_4$ einzusetzen, worin X dieselbe Bedeutung wie in Formel (I) besitzt. Nochmals Vergleichbares gilt für die Kombination eines Silans der Formel (I) mit einem (oder mehreren) Metallalkoxid(en). Selbstverständlich lassen sich die drei vorgenannten bevorzugten Ausgestaltungen auch untereinander kombinieren.

Es ist erfindungsgemäß bevorzugt (und zwar in Kombination mit allen vorgenannten Ausführungsformen), dass die für die Herstellung der Hybridpolymere eingesetzten Silane zumindest teilweise solche sind, in denen a gleich 1 oder - in selteneren Fällen - gleich 2 ist. Dementsprechend sind in spezifischen Ausgestaltungen der vorliegenden Erfindung solche Hybridpolymere als Beschichtungsmaterialien oder Kaschiermassen für die vorliegende Erfindung bevorzugt, die neben dem anorganischen Netzwerk ein organisches Polymernetzwerk aufweisen. Ein solches Netzwerk kann beispielsweise durch Öffnung von an $R^1$ gebundenen Epoxygruppen entstehen. Alternativen sind beispielsweise Reste $R^1$, die Acrylat, -Methacrylat- oder Vinylgruppen enthalten. Hier kann z.B. durch UV-Bestrahlung eine organische Vernetzung durch Polymerisation (Polyaddition) der Doppelbindungen bewirkt werden. Silane mit derartigen oder ähnlichen/vergleichbaren Resten $R^1$ sind aus dem Stand der Technik in großer Anzahl bekannt.

Die Ausgangsmaterialien werden in der Regel nach dem bekannten Sol-Gel-Verfahren hydrolytisch kondensiert oder teilkondensiert, wobei in der Regel ein Katalysator die Kondensationsreaktion in bekannter Weise initiiert bzw. beschleunigt. Die derart hergestellten Beschichtungsmaterialien werden in der Regel als Lacke (Lösungen, Suspensionen) appliziert, die anschließend durch Abdampfen von Lösungsmittel, einer weitergehenden anorganischen Nachvernetzung und/oder einer organischen Vernetzung ausgehärtet werden. Wenn eine organische Vernetzung erfolgen soll, kann dem Lack je nach Bedarf ein geeigneter Katalysator oder Initiator beigemischt werden, und die Vernetzung erfolgt thermisch oder mit Hilfe von aktinischer Strahlung (z.B. UV- oder anderer Lichtstrahlung), ggf. auch redoxkatalysiert. Eine anorganische Nachvernetzung ist häufig mit dem Abdampfen von Lösungsmittel verknüpft. All dies ist seit langem bekannt und in einer Vielzahl von Publikationen schriftlich niedergelegt.

Als Lösungsmittel dient vorzugsweise Wasser, gegebenenfalls aber auch ein Alkohol. Wasserbasierte Lacke sind aus Umweltschutzgründen zu bevorzugen.

Die genannten Hybridpolymere bzw. Lacke/Kaschiermaterialien besitzen auch aufgrund ihrer intrinsischen Barriereeigenschaften hervorragende Barriereeigenschaften, wenn sie in Kombination mit anorganischen Barriereschichten eingesetzt werden. Die Qualität der Barriere lässt sich dabei nochmals verbessern, wenn die Hybridpolymere neben dem anorganischen Polymer-Netzwerk auch ein organisches Polymer-Netzwerk aufweisen. Diese doppelte Vernetzungsstruktur unterscheidet sie ganz besonders von den üblicherweise in Verbunden mit keramischem Material verwendeten organischen Teilschichten, z.B. aus Acrylat. Die Wirkung von Acrylatschichten beruht nur auf ihrer intrinsischen Barrierewirkung und auf der Entkopplung mehrerer anorganischer, aus der Gasphase aufgebrachter Schichten. Dagegen können die hybridpolymeren Materialien darunter liegende Barriereschichten aus anorganischem Material (Metall- oder Keramikschichten) zusätzlich dichten, indem sie, weil sie relativ dünnflüssig sind, deren Fehlstellen (Pinholes) füllen können. Was sie ebenfalls gegenüber organischen Schichten hervorhebt, ist die Fähigkeit, über Metall-Sauerstoff-Metall-Brücken an die Oberflächen der rein anorganischen Schichten anzubinden. Diese kovalente Anbindung stellt weiterhin eine intrinsische, die Gesamtwirkung erhöhende Barrierewirkung der Schichtenkombination dar. Aufgrund des Vermögens, kovalent an anorganische Schichten anzubinden, können die erfindungsgemäß einsetzbaren Hybridpolymer-Schichten auch Primer-Funktionen erfüllen. Darüber hinaus besitzen sie ausgezeichnete Entkopplungseffekte. Wegen ihrer Fähigkeit, Fehler und Unebenheiten darunterliegender Schichten auszugleichen, können sie weiterhin als Planarisierungsschichten fungieren. Schließlich sind sie vollständig aushärtbar: Aus dem Stand der Technik ist bekannt, dass sich aus solchen Hybridpolymeren extrem kratzfeste Schichten herstellen lassen.

Ergebnisse für Sauerstoff- (OTR) und Wasserdampfdurchlässigkeit (WVTR) von spezifischen Folienverbünden sind in **Tabelle 2** gezeigt.

Tabelle 2:

| Folie | Schichtaufbau | WVTR [g/m$^2$d] @ 38/90 (Ca-Test) |
|---|---|---|
| PET | AlOx | $4*10^{-2}$ |
| PET | AlOx / Lack (A) oder (B) | $7*10^{-3}$ |
| PET | AlOx / Lack (A) oder (B) / AlOx | $1,0*10^{-3}$ |

(fortgesetzt)

| Folie | Schichtaufbau | WVTR [g/m²d] @ 38/90 (Ca-Test) |
|-------|---------------|--------------------------------|
| PET | AlOx / Lack (A) oder (B) / AlOx / Lack (A) oder (B) | $3*10^{-4}$ |
| PET | ZnSnOx / Lack (A) / ZnSnOx | $2,0*10^{-4}$ |

Zusätzliche Hybridpolymerschichten der oben genannten Art können als Schutzschichten fungieren, die vorzugsweise in dickeren Schichten (über 1 μm) aufgetragen werden, beispielsweise als UV-Schutz oder zu dem Zweck, dem Verbund Feuchteresistenz zu verleihen. Dafür werden derartige Schichten üblicherweise als eine äußerste Schicht des Verbunds ("Topcoat") aufgetragen.

Schichten aus den erfindungsgemäß einsetzbaren anorganisch-organischen Hybridmaterialien fungieren dementsprechend in den erfindungsgemäßen Barriereverbundschichten nicht nur als Barriere für Gase und gasförmiges Wasser, sondern auch als Primer, Planarisierungschicht, entkoppelnde Zwischenschicht und Schutzschicht mit vielfältigen Schutzeigenschaften. Nur am Rande sei erwähnt, dass Primerschichten für die vorliegende Erfindung anstatt aus Hybridpolymer in Einzelfällen auch aus organischen Schichten bestehen könnten.

Als Material für die anorganischen Barriereschichten eignen sich vor allem Metalle und Metalllegierungen, deren Oxide, Nitride und Carbide, Oxide, Nitride und Carbide des Siliciums sowie entsprechende Mischverbindungen und andere keramische Materialien. Günstig sind beispielsweise Oxide des Aluminiums oder Siliciums. Auch Silazane sind geeignet. Diese werden je nach eingesetztem Material und Bedarf aus der Gasphase aufgebracht, beispielsweise aufgesputtert oder aufgedampft. Es können Vakuumtechniken oder vakuumfreie Techniken eingesetzt werden. Das Aufdampfen hat den Vorteil, billiger und schneller durchführbar zu sein als das Sputtern. Mit letzterem kann man jedoch eine höhere Dichte der Schicht und damit eine bessere Barrierewirkung dieser Schicht erreichen.

Das anorganisch-organische Hybridmaterial der vorliegenden Erfindung wird aus der flüssigen Phase, z.B. durch Nasslackbeschichtung, aufgebracht. Dadurch, dass das Beschichtungsmaterial niederviskos, gut benetzend und den anorganischen Barriereschichten chemisch verwandt ist, können makroskopische und mikroskopische Defekte in den anorganischen Schichten zumindest teilweise kompensiert und gegebenenfalls die sowohl bei aufgedampften als auch bei aufgesputterten Schichten vorhandenen Defekte (Pinholes) ausgefüllt werden. Die durch den Synergieeffekt verbesserte Barrierewirkung, d.h. durch die Füllung von Poren bzw. durch die kovalente Anbindung an anorganische Schichten, verbesserte Barrierewirkung ist der große Vorteil von nasschemisch aufgetragenen hybridpolymeren Zwischenschichten gegenüber Schichtsystemen, bei denen alle Schichten aus dem Vakuum aufgebracht werden.

In der Regel ist es besonders günstig, auf der (oder einer) Substratoberfläche zuerst eine anorganische Barriereschicht anzuordnen und darüber mindestens eine Schicht aus anorganisch-organischem Hybridmaterial, gefolgt von einer zweiten anorganischen Barriereschicht. Bei einer derartigen Anordnung liegt der Permeationskoeffizient um eine Größenordnung unter der der umgekehrten Anordnung (Substrat - anorganischorganisches Hybridpolymer - anorganische Barriere). Diese Anordnung ist jedoch nicht in allen Fällen ohne weitere Schichten oder ohne Vorbehandlung einsetzbar. Beispielsweise haften anorganische und hybridpolymere Schichten auf Polytetrafluorethylen nicht. Fluorierte Polyethylene wie PTFE, PVF, ETFE sind jedoch als Substratmaterialien häufig günstig, weil sie transparent für UV-Licht, UV-stabil und damit für Anwendungen im Außenbereich geeignet sind. Ein weiterer Nachteil dieser Polymere ist deren hohe Oberflächenrauigkeit. In derartigen Fällen wird deshalb nach Coronavorbehandlung vorzugsweise eine Schicht aus anorganisch-organischem Hybridpolymer als Primer auf das Substrat aufgetragen. Diese Schicht wird zusätzlich zu dem erfindungsgemäß einzusetzenden Sandwichverbund aus anorganischer Schicht / Hybidpolymerschicht / anorganischer Schicht verwendet.

Barriereschichtverbunde mit der Anordnung: anorganische Schicht / anorganischorganisches Hybridpolymer / anorganische Schicht erzielen bessere Barrierewerte, wenn die Dicke der anorganisch-organischen Hybridpolymer-Schicht bei < 1 μm liegt, als wenn sie darüber liegt, wie oben dargestellt. Bevorzugt liegt die Dicke dieser Schicht bei unter 500nm, im Idealfall sogar unterhalb von 200 nm. Optimal sind Werte bei 50 nm, falls eine Abdeckung der Erhebungen in der Topologie der auf dem Substrat aufgedampften anorganischen Schicht damit erreicht werden kann (siehe **Figur 2,** in der links eine elektronenmikroskopische Aufnahme eines gängigen Barriereverbunds und rechts eine solche einer erfindungsgemäßen Anordnung mit zwei anorganischen Schichten und einer zwischenliegenden anorganisch-organischen Hybridpolymerschicht zu sehen sind). Daraus ergibt sich, dass das Substrat (die Folie) vorzugsweise eine extrem niedrige Rauhigkeit aufweisen sollte. Falls dies nicht möglich ist, empfiehlt es sich, eine Planarisierungsschicht unter die erste Aufdampfschicht zu applizieren. Auch diese kann wie erwähnt als anorganisch-organische Polymerhybridschicht ausgestaltet sein.

Die einfachste Methode der Herstellung einer solchen Struktur ist das Verbinden zweier anorganisch beschichteter Substratfolien über eine anorganisch-organische (hybridpolymere) Klebstoffschicht (Kaschierschicht) mit den anorganischen Schichten gegeneinander (PET/anorganische Schicht/hybridpolymerer Kleber/...) oder über einen herkömmlichen Kaschierkleber mit den Hybridpolymeren gegeneinander (PET/anorganische Schicht/Hybridpolymer/kommerzieller Kaschierkleber/...). Alternativ dazu kann eine anorganisch beschichtete Substratfolie mit einem anorganisch-organischen Hybridmaterial lackiert und mit einer weiteren anorganischen Schicht versehen werden. Weitere Schichten können in alternierender Reihenfolge folgen. Beide Verfahren sind für die vorliegende Erfindung einsetzbar.

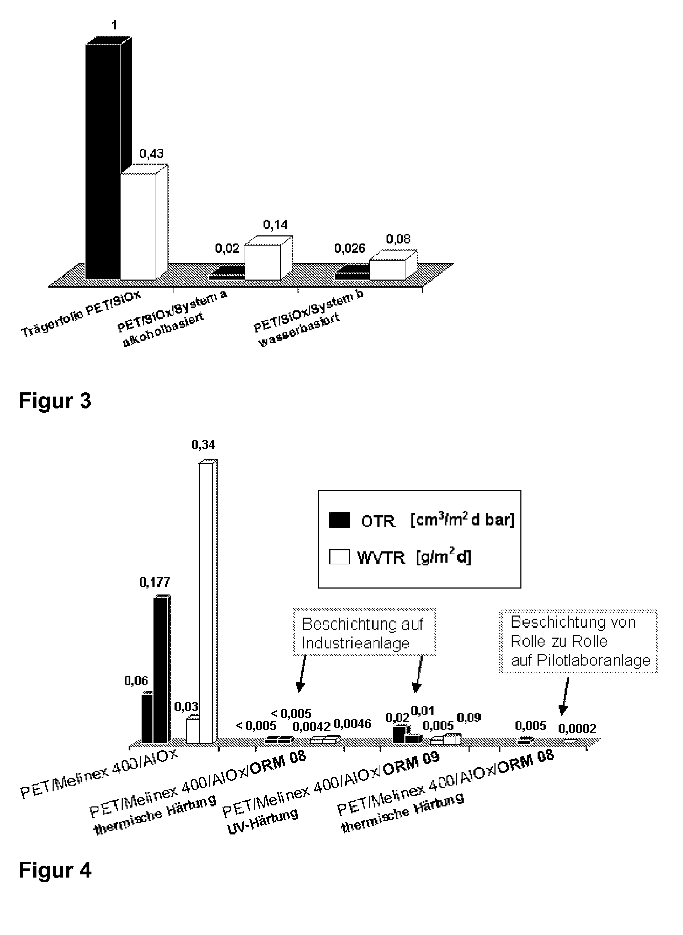

In einer bevorzugten Ausgestaltung der Erfindung werden UV-härtbare Barrierebeschichtungsmaterialien auf Wasserbasis eingesetzt. Bisher genutzte, UV-härtbare anorganisch-organische Hybridpolymere wurden ausschließlich in Gegenwart von Alkoholen Sol-Gel-vernetzt. Überraschenderweise konnte festgestellt werden, dass der Ersatz von alkoholischen Barrierelacken durch Lacke auf Basis von wasserbasierten Systemen in den erfindungsgemäßen Verbundsystemen zu einer Verbesserung der Dampfsperreigenschaften führt. Aus **Figur 3** geht hervor, dass die Sauerstoffdurchlässigkeit fast unverändert war, während die Wasserdampfdurchlässigkeit auf die Hälfte gesenkt war (System a bezeichnet Lack (A), System b bezeichnet Lack (B) des Beispiels 1).

In einer weiteren, ebenfalls bevorzugten Ausführungsform der Erfindung werden Barrierelacke aus anorganisch-organischem Hybridmaterial eingesetzt, die zusätzlich Partikel, insbesondere Oxidpartikel enthalten. Besonders bevorzugt ist es, diese Ausführungsform mit organisch vernetzbaren Hybridmaterialien zu realisieren. Als Partikel werden Aluminiumoxid- und/oder Siliciumoxidpartikel bevorzugt; die Partikelgröße liegt günstigerweise im Bereich unterhalb des Durchmessers der Barriereschicht aus anorganisch-organischem Hybridmaterial und vorzugsweise im Bereich von 20 bis 120, insbesondere von 30 nm bis 100, stärker bevorzugt bei etwa 50 nm. Wegen des geringen Durchmessers dieser Partikel sind diese nicht in einfacher Weise homogen in die Barrierelacke der Erfindung einarbeitbar. Jedoch gelang dies bei Einsatz von wässrigen bzw. alkoholischen $SiO_2$-Solen sowie einer wässrigen Dispersion von $Al_2O_3$-Partikeln. Die $SiO_2$-Partikel konnten sowohl in thermisch als auch in mit Hilfe von Licht (UV) härtende Lacksysteme bis zu einer Menge von ca. 5-30, insbesondere 5-6 Massen-% bzw. - bei UV-härtenden Systemen - bis ca. 11 Massen-% eingearbeitet werden. Die mit Füllstoff modifizierten Systeme wurden auf PET/SiOx (Sputt.)- und PET/AlOx (Sputt.) -Folien aufgetragen. Die Ergebnisse sind in **Tabelle 3** gezeigt. Eine Verminderung der Transparenz der mit partikelhaltigen Systemen beschichteten Folien im Vergleich zu den Beschichtungen ohne Partikel konnte in den untersuchten Konzentrationsbereichen nicht festgestellt werden.

Ein thermisch härtendes System (durchgeführt mit Lack (A) des Beispiels 1) zeigte in Kombination mit $SiO_2$-Partikeln eine weitere Verringerung der OTRs um den Faktor 10 und der WVTRs um den Faktor 2,5 (siehe **Tabelle 3**).

Tabelle 3

| Folienmuster | WVTR (23˚C, 85 % r.F.) | OTR (23˚C, 50 % r.F.) |
|---|---|---|
| PET/SiOx | 0,1 | 0,2 |
| PET/SiOx/Lack (A) | 0,05 | 0,01 |
| PET/SiOx/ Lack (A) + SiO$_2$-Partike | 0,003 | 0,004 |

Auch ein UV-härtbarer Lack erreichte durch die Kombination mit $SiO_2$-Partikeln die Messgrenze für die OTRs: 0,005 cm$^3$/m$^2$ d bar. Auch eine deutliche Verbesserung der Wasserdampfbarriereeigenschaften im Vergleich zu den Ausgangswerten von > 0,1 g/m$^2$ d (0,04 g/m$^2$d) konnte erreicht werden.

Die Verwendung von sphärischen und/oder oberflächenfunktionalisierten $SiO_2$-Partikel führt zu nochmals deutlich erniedrigten Barrierewerten.

In ganz besonders bevorzugter Weise werden für die Zwecke der vorliegenden Erfindung Barrierelacke auf Wasserbasis eingesetzt, die zusätzlich die genannten Partikel enthalten.

In einer speziellen Ausführungsform der Erfindung werden Sandwich-Systeme mit einer höheren Zahl aus alternierenden anorganischen und anorganisch-organischen Hybridpolymer-Schichten bereitgestellt. Auch hier besteht das Grundelement solcher Systeme wiederum aus einer dünnen, anorganisch-organischen Hybridmaterial-Schicht, die zwischen zwei anorganische Schichten (Metall- oder Metalloxid-Schichten) eingebettet ist. Für die Dicke dieser Schicht gilt das Gleiche, das oben zu den anorganisch-organischen Hybridpolymerschichten ausgeführt wurde.

Die Barriereschichten aus anorganisch-organischem Hybridmaterial sind, wie voranstehend erläutert, extrem dünn. Den Erfindern ist es gelungen, solch dünne Schichten erfolgreich auf die jeweilige Unterlage aufzubringen und zu gut dichtenden Barriereschichten auszuhärten. Dabei ist zu berücksichtigen, dass die angestrebte Barrierewirkung natürlich nur dann erreicht werden kann, wenn die Barriereschicht einen geschlossenen Film auf der Unterlage ausbildet, wenn die anorganische und ggf. organische Vernetzung in ausreichendem Umfang stattgefunden hat und wenn die ggf. unter der anorganisch-organischen Schicht befindliche rein anorganische Barriereschicht ausreichend dicht ist. Dies kann unter Einhaltung einer oder mehrerer der nachstehenden Verfahrensbedingungen erreicht werden:

1. Messungen der dynamischen Viskositäten haben ergeben, dass die anorganisch-organischen Hybridlacke in den vorzugsweise eingesetzten Konzentrationen in der Regel als fast ideale Newton'sche Flüssigkeit vorliegen. Die dynamischen Viskositäten liegen vorzugsweise zwischen ca. 0,008 und 0,05 Pas. In einer besonders günstigen Ausführungsform der Erfindung werden daher Beschichtungslacke mit sehr geringer effektiver Viskosität eingesetzt, beispielsweise im Bereich von 0,003 bis 0,03 Pas. Die Viskositäten der Kaschiermaterialien liegen dagegen im Bereich von 0,1 bis 200 Pas. Werden bei der Herstellung der Lacke oder Kaschiermaterialien infolge der hydrolytischen Kondensation im Sol-Gel-Verfahren diese Werte überschritten, empfiehlt es sich, sie vor dem Auftrag entsprechend zu verdünnen. Der Feststoffgehalt liegt nach dem ggf. erfolgenden Verdünnen in der Regel bei nicht wesentlich über 10-20 Gew.-%.

2. Die eingesetzten Silane der Formel (I) besitzen zwei oder - vorzugsweise - drei hydrolysierbare Gruppen. Dadurch entsteht ein relativ dichtes anorganisches Netzwerk aus Si-O-Si-Brücken.

3. Die Silane der Formel (I) werden in Kombination mit Silanen der Formel $SiX_4$ eingesetzt. Dies erhöht die anorganische Vernetzung weiter und macht die Beschichtung glasartiger.

4. Anstelle oder zusätzlich zur unter Punkt 3. erläuterten Maßnahme können hydrolysierbare Metallverbindungen zugesetzt werden, beispielsweise des Aluminiums, des Zirkoniums und/oder des Titans. Hierdurch wird die organische Vernetzung noch dichter.

5. Als Silane können in bevorzugter Weise organisch vernetzbare Silane, beispielsweise solche mit einem Glycidyl-, Anhydrid- oder (Meth-)Acrylatrest eingesetzt werden, wobei ggf. geeignete Katalysatoren/Initiatoren für eine organische Vernetzung dieser Reste zugegeben werden. Nach dem Auftragen des Lacks wird dieser thermisch oder photochemisch nachbehandelt, wobei sich zusätzlich zu dem anorganischen Si-O-Si-Netzwerk, das durch die hydrolytische Kondensation erzeugt wird, ein organisches Netzwerk ausbildet. Dieses erhöht die Dichtigkeit der anorganisch-organischen Schicht für hindurchtretende Gasmoleküle.

6. Die hydrolytische Kondensation der Silanverbindungen der Formel (I) erfolgt vorzugsweise mit Hilfe eines sauren oder basischen Katalysators. Dieser kann so ausgewählt werden, dass er gleichzeitig als Komplexligand für eine oder mehrere zugesetzte Metallverbindung(en) dienen kann: Dies verlangsamt die hydrolytische Kondensation und befördert den Aufbau einer gleichmäßig vernetzten Struktur.

7. Ein wichtiger Faktor für das Gelingen einer dichten Schicht ist auch die Oberflächenspannung des Lacks, da eine ausreichende Benetzung zum Substrat bzw. der darunterliegenden ausschließlich anorganischen Schicht gewährleistet sein muss, um einen gleichmäßigen Lackauftrag sicherstellen zu können. Diese liegt vorzugsweise im Bereich von etwa 20-35 mN/m.

8. Mehrere Verfahren wurden daraufhin untersucht, ob sich damit die erfindungsgemäßen Lackschichten in einer möglichst dünnen Schicht mit einer Obergrenze von < 1 μm als geschlossene Filme auftragen lassen. Denn wie bereits oben erwähnt, hängt die Barrierewirkung der anorganisch-organischen Hybridpolymer-Schichten im wesentlichen von der Geschlossenheit der Filme, von einer optimalen Vernetzung des anorganischen und des organischen Netzwerks und der Dichtigkeit der darunter liegenden anorganischen Aufdampfschicht ab.
Getestet wurden Auftragsverfahren wie Bead coating, Reverse gravure und Curtain coating. Alle diese Verfahren haben die Eigenschaft, dünne Schichten in geschlossener Form applizieren zu können.
Das "Reverse gravure" Verfahren erfolgt mit Hilfe eines gegenläufigen Rasterwalzenauftrags. Die unter Punkt 1. oben erwähnten dynamischen Viskositäten eignen sich gut für dieses Verfahren. Die dabei entstehende Struktur der anorganisch-organischen Hybridschicht hat sich als sehr günstig erwiesen.

9. Aufgrund der Empfindlichkeit der Schichten ist es empfehlenswert, den Folientransport ohne Kontakt zur Unterlage (z.B. Walzen) zu bewerkstelligen. Der Stand der Technik stellt auch für das Rolle-zu-Rolle Verfahren entsprechend geeignete Maßnahmen zur Verfügung.

10. Außerdem sollten Umgebungsbedingungen gewählt werden, die die Anwesenheit von Staubpartikeln oder sonstigen teilchenförmigen Schwebstoffen in der Luft möglichst gering halten, wenn nicht ausschließen.

11. Beim Verdampfen der Lacklösungsmittel werden, wie bereits oben erwähnt, in der Regel (zusätzliche) anorganische Vernetzungsschritte eingeleitet. Dies hängt mit dem chemischen Gleichgewicht der anorganischen Vernetzungsreaktion zusammen (Polykondensation). Sofern organisch vernetzbare funktionelle Gruppen vorhanden sind, wird zusätzlich eine gewisse Aktivierungsenergie benötigt, damit die Vernetzungsreaktionen initiiert werden. Diese kann thermisch oder durch Bestrahlen eingetragen werden. Problematisch hierbei kann die Thermolabilität der Kunststofffolien sein, die sich bei zu hohen Temperaturen thermoplastisch verformen können. Bei der Trocknung und Ausbildung der anorganisch-organischen Hybridpolymer-Schichten ist es also empfehlenswert, Bedingungen einzuhalten, die sowohl der jeweiligen thermischen Beständigkeit der verwendeten Polymerfolie als auch den Aushärtebedingungen des jeweiligen Lackes Rechnung tragen.

Um diesen Umständen Rechnung zu tragen, erfolgt in einer bevorzugten Ausgestaltung die Trocknung deshalb mit einem hohen laminaren Luftstrom, gefolgt von einer gedrosselten Infrarot-Bestrahlung. Die Bahntemperatur sollte dabei so gesteuert werden, dass die Kunststofffolie nicht angegriffen wird. Für die Beschichtung von PET-Folien sollten beispielsweise in der Regel ca. 90˚ bis 120˚C nicht überschritten werden. Es ist trotzdem möglich, die Temperatur der Lackschicht im nassen Zustand deutlich über diese Temperatur zu bringen, beispielsweise auf ca. 20K darüber, um die benötigte Aktivierungsenergie für die Initiierung der organischen Vernetzungsreaktion bereitzustellen. Die wichtigste Voraussetzung dafür ist die Verdampfungskälte, die beim Abdampfen des Lösungsmittels entsteht. Alternativ zur IR-Bestrahlung kann eine UV-Bestrahlung erfolgen, z.B. wenn sich organische Gruppen der Silane des Lacks dadurch vernetzen lassen.

Die Entkopplung von Heißluft-Trocknung und Bestrahlung wird durch den Einsatz einer separaten Trocknungsstation für Heißluft wesentlich erleichtert, da die Einzelschritte getrennt in zwei Aggregaten vorgenommen werden können.

Die Verbesserungen, die das Rolle-zu-Rolle Verfahren unter Einsatz der vorgenannten Maßnahmen bietet, sind aus Figur 4 ersichtlich. Die Beschichtung einer PET/Melinex 40 Folie, die mit AIO$_x$ bedampft/besputtert ist, mit dem Lack "ORM 8", entsprechend Lack (A) aus Beispiel 1, der anschließend thermisch gehärtet wurde, führt bei Anwendung dieser Maßnahmen auf einer Rolle-zu-Rolle Pilotanlage zu einer Halbierung der Wassdampfdurchlässigkeit, verglichen mit einer nach Standardmethoden mit denselben Materialien in derselben Dicke beschichteten Folie.

Allgemeines Ausführungsbeispiel

Ausgangsmaterialien:

10-40 Mol-% Tetraalkoxysilan
10-90 Mol-% organisch vernetzbares Silan,
5-35 Mol-% Metallalkoholat, ausgewählt unter Alkoholaten des Aluminium, Zirkoniums und/oder Titans.
Ggf. ein Komplexierungsmittel im Falle relativ reaktiver Metallalkoholate, z.B. Triethanolamin, Acetessigsäureethylester, Acetylacetat, Aminopropyltrialkylsilan.

Die Metallalkohole werden optional mit dem Komplexierungsmittel umgesetzt und zu der Silankomponente gegeben und hydrolysiert.

Beispiel 1

Herstellung von Lack (A)

15 Mol-% Tetramethoxysilan (TMOS)
20 Mol-% Glycidylpropyltrimethoxysilan (GLYMO)
10 Mol-% Zirkoniumpropylat
10 Mol-% Aluminium-sek.butylat
10 Mol-% Acetessigsäureethylester

Zirkoniumpropylat und Aluminium-sek.butylat wurden in Acetessigsäureethylester komplexiert, um ihre Reaktionsfähigkeit zu senken. Nach Zugabe der Silane wurde die Mischung säurekatalysiert (durch Zugabe wässriger HCl) hydrolysiert. Dabei setzte eine relativ langsame anorganische Vernetzungsreaktion ein, die beim Stehenlassen der Mischung noch über mehrere Wochen hindurch zu einer Erhöhung der Viskosität führt.

Herstellung von Lack (B)

Die Herstellung des Lacks aus den obigen Komponenten wurde wiederholt mit der Änderung, dass die bei der Reaktion freigewordenen Alkohole nach der Synthese im Vakuum abgezogen und das dabei verloren gegangene Lösungsmittel durch Wasser ersetzt wurde.

Die Lacke (A) und (B) wurden verwendet, um mit AlO$_x$ bedampfte PET-Folien (Melinex M400 von Dupont, 75 $\mu$m dick) zu beschichten. Zu diesem Zweck wurde der Feststoffgehalt der Lacke, der zuvor bei ca. 40% gelegen hatte, mit Wasser auf ca. 10% verdünnt. Nach Applikation der Lacke unter berührungslosem Transport der Folien bei Raumtemperatur bzw. nur wenig darüber und unter Ausschluss von Staubpartikeln wurden die Lacke durch separate Heißluft-Trocknung bei 90˚C und IR-Bestrahlung für einen Zeitraum von z. B. 80 s (bei 3m/min) gehärtet. Ein Teil der Folien wurde anschließend mit einer weiteren AlO$_x$-Schicht bedampft. Von diesen wurde wiederum ein Teil nochmals mit demselben Lack als Deckschicht überschichtet. Die Ergebnisse sind in Tabelle 2 zusammengefasst.

Beispiel 2

Beispiel 1 wurde wiederholt, wobei jedoch anstelle einer mit AlOx bedampften Folie eine solche eingesetzt wurde, die mit einer 200 nm dicken ZnSnO$_x$ Schicht besputtert worden war. Nach dem Auftrag des Lacks und dessen Aushärtung wurde diese mit einer zweiten, ebenfalls 200 nm dicken ZnSnO$_x$-Schicht versehen. Mit Hilfe des Calciumspiegeltests wurde eine Wasserdampfdurchlässigkeit von 2 x 10$^{-4}$ g/m$^2$d bei 38˚C, 90% rel. F. gemessen (Tabelle 2).

Beispiel 3

Ausgangsmaterialien:

55-80 Mol-% Methacryloxypropyltrimethoxysilan
25-45 Mol-% Metallalkoholat, im Molverhältnis 1:0,5-1 mit Methacrylsäure komplexiert
wobei das Metallalkoholat ausgewählt wurde unter Alkoholaten, insbesondere solchen mit 1 bis 4 Kohlenstoffatomen, des Al und/oder des Zr und/oder des Ti.

Die Mischung wurde in vergleichbarer Weise wie in Anspruch 1 hydrolysiert.

Die Lackbeschichtung erfolgte wie in Beispiel 1 beschrieben, wobei jedoch der Lack zur Unterstützung der Aushärtung nicht mit Hilfe von IR-Strahlung bestrahlt wurde. Stattdessen erfolgte eine Vernetzung der Methacrylgruppen unter UV-Bestrahlung mit 5-6 J/cm$^2$.

**Patentansprüche**

1. Hochbarriereverbund, umfassend

   (a) ein Substrat,
   (b) eine erste Schicht aus einem ausschließlich anorganischen Material,
   (c) eine erste Schicht aus einem anorganisch-organischen Hybridmaterial, und
   (d) eine zweite Schicht aus einem ausschließlich anorganischen Material, **dadurch gekennzeichnet, dass** die Schicht aus anorganisch-organischem Hybridmaterial unmittelbar zwischen den beiden Schichten aus ausschließlich anorganischem Material angeordnet ist und eine Dicke von unter 1 $\mu$m aufweist.

2. Hochbarriereverbund nach Anspruch 1, worin die Schicht aus anorganisch-organischem Hybridmaterial eine Dicke von unter 500 nm, vorzugsweise von unter 200 nm, und am meisten bevorzugt von unter 100 nm aufweist.

3. Hochbarriereverbund nach Anspruch 1 oder 2, worin die erste Schicht aus einem ausschließlich anorganischen Material unmittelbar zwischen dem Substrat und der ersten Schicht aus einem anorganisch-organischen Hybridmaterial angeordnet ist.

4. Hochbarriereverbund nach einem der voranstehenden Ansprüche, umfassend mindestens zwei Schichten aus einem anorganisch-organischen Hybridmaterial, wobei die Schichten aus ausschließlich anorganischem Material und die Schichten aus anorganisch-organischem Hybridmaterial alternierend angeordnet sind.

5. Hochbarriereverbund nach Anspruch 1, worin eine erste ausschließlich anorganische Schicht direkt auf dem Substrat aufgebracht ist oder worin eine weitere polymere Schicht, bevorzugt aus einem anorganisch-organischen Hybridmaterial, als Primer- oder Planarisierungsschicht zwischen einer ersten ausschließlich anorganischen Schicht und dem Substrat aufgebracht ist.

**6.** Hochbarriereverbund nach einem der voranstehenden Ansprüche, worin das anorganisch-organische Hybridmaterial ein anorganisches Netzwerk und ein organisches Netzwerk aufweist.

**7.** Hochbarriereverbund nach einem der voranstehenden Ansprüche, worin das anorganisch-organische Hybridmaterial hergestellt wurde unter Verwendung mindestens eines Silans der Formel (I)

$$R^1{}_aR^2{}_bSiX_{4-a-b} \qquad (I)$$

worin $R^1$ ein Rest ist, der einer organischen Vernetzung zugänglich ist, $R^2$ ein organischer Rest ist, der keiner organischen Vernetzung zugänglich ist und X OH oder eine Gruppe bedeutet, die unter Hydrolysebedingungen eine Kondensationsreaktion unter Ausbildung von Si-O-M mit M = Metall oder Silicium eingehen kann, a und b jeweils 0, 1 oder 2 sind und 4-a-b 1, 2 oder 3 ist.

**8.** Hochbarriereverbund nach Anspruch 7, worin das anorganisch-organische Hybridmaterial hergestellt wurde unter zusätzlicher Verwendung eines Silans der Formel $Si(OR^2)_4$, worin $R^2$ dieselbe Bedeutung wie für Formel (I) besitzt, und/oder eines oder mehrerer in das Hybridmaterial einkondensierbarer Metallverbindungen der Formel $M^{III}L_3$ oder $M^{IV}L_4$, worin $M^{III}$ ein dreiwertiges Metall und $M^{IV}$ ein vierwertiges Metall bedeuten und L eine Alkoxygruppe oder einen Komplexliganden oder einen Zahn eines mehrzähnigen Komplexliganden bedeutet.

**9.** Hochbarriereverbund nach Anspruch 7 oder 8, worin als Silan der Formel (I) zu mindestens 50 Mol-%, vorzugsweise zu mindestens 80 Mol-% und ganz besonders bevorzugt zu 100 Mol-% ein solches eingesetzt wird, in welchem 4-a-b 3 bedeutet.

**10.** Hochbarriereverbund nach einem der Ansprüche 7 bis 9, worin im Silan der Formel (I) a 1 bedeutet und worin, vorzugsweise unter Epoxid-Ringöffnung oder nach UV-Bestrahlung eines acrylat- oder vinylgruppenhaltigen Restes $R^1$, ein organisches Netzwerk entstanden ist.

**11.** Hochbarriereverbund nach einem der Ansprüche 7 bis 10, worin das anorganisch-organische Hybridmaterial nach dem Sol-Gel-Verfahren auf wässriger Basis hergestellt wurde.

**12.** Hochbarriereverbund nach einem der voranstehenden Ansprüche, worin das anorganisch-organische Hybridmaterial Oxidpartikel mit einem Durchmesser von 20-120 nm aufweist.

**13.** Verfahren zum Herstellen eines Hochbarriereverbunds nach einem der Ansprüche 1 bis 12, **dadurch gekennzeichnet, dass** die Schicht(en) aus einem anorganisch-organischen Hybridmaterial durch den Auftrag eines Lackmaterials mit einer Viskosität von 0,002 bis 0,02 Pas und/oder einer Oberflächenspannung im Bereich von 25 bis 35 mN/m oder eines Kaschiermaterials mit einer Viskosität von 0,1 bis 200 Pas auf dem ggf. bereits mit einem anorganischen Material beschichteten Substrat aufgebracht wird/werden, wobei

- das Substrat unter einer Ausgabevorrichtung vorbeitransportiert wird, aus der das Lackmaterial/Kaschiermaterial auf das Substrat aufgebracht wird,
- der Transport des Substrats ohne Kontakt zu den Transport bewirkenden Mitteln erfolgt, und
- ggf. die Anwesenheit von Staubpartikeln während des Aufbringens weitgehend unterdrückt ist.

**14.** Verfahren nach Anspruch 13, worin der Hochbarriereverbund die Form einer aufrollbaren Folie besitzt und das Lackmaterial/Kaschiermaterial von Rolle zu Rolle aufgebracht wird.

**15.** Verfahren nach Anspruch 13 oder 14, **dadurch gekennzeichnet, dass** das Lackmaterial bzw. Kaschiermaterial hergestellt wurde unter Verwendung von Silanen, die eine organisch vernetzbare Gruppe enthalten, und dass nach Aufbringen dieses Materials auf dem Substrat die dabei gebildete Schicht derart behandelt wird, dass vorhandene organisch vernetzbare Gruppen ein organisches Netzwerk ausbilden.

**16.** Verfahren nach Anspruch 15, **dadurch gekennzeichnet, dass** die Vernetzung organischer Gruppen durch Wärmeeintrag und ggf. durch Bestrahlen erfolgt.

**Figur 1**

**Figur 2**

**Figur 3**

**Figur 4**

**Figur 5(a)**

**Figur 5(b)**

**Figur 5(c)**

EUROPÄISCHES PATENTAMT
European Patent Office
Office européen des brevets

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2003/077462 A1 (UTZ HELMAR [CH] ET AL UTZ HELMAR [DE] ET AL) 24. April 2003 (2003-04-24) * Absätze [0019], [0027]; Abbildung 3 * ----- | 1-16 | INV. C09D183/04 C08J7/04 H01L51/52 |
| X | EP 0 792 846 A (FRAUNHOFER GES FORSCHUNG [DE]) 3. September 1997 (1997-09-03) * Seite 3, Zeilen 4-8; Ansprüche 1,9; Beispiel 4 * ----- | 1-16 | |

**RECHERCHIERTE SACHGEBIETE (IPC)**

C09D
C08J
H01L

Der vorliegende Recherchenbericht wurde für alle Patentansprüche erstellt

| Recherchenort | Abschlußdatum der Recherche | Prüfer |
|---|---|---|
| München | 8. September 2009 | Buestrich, Ralf |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
..............................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 09 16 3519

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-09-2009

| Im Recherchenbericht angeführtes Patentdokument | Datum der Veröffentlichung | Mitglied(er) der Patentfamilie | Datum der Veröffentlichung |
|---|---|---|---|
| US 2003077462 A1 | 24-04-2003 | KEINE | |
| EP 0792846 A | 03-09-1997 | AT 273253 T<br>ES 2225907 T3<br>US 6503634 B1 | 15-08-2004<br>16-03-2005<br>07-01-2003 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6570325 B2
- WO 08122292 A
- US 20060063015 A
- US 2008196664 A
- US 2008305359 A
- US 7442428 B
- US 2008167413 A
- US 7449246 B
- US 2007224393 A
- US 2008237615 A
- EP 1384571 B1
- EP 1563989 A
- EP 1975214 A1
- DE 19659286 C2
- EP 802218 B1

**In der Beschreibung aufgeführte Nicht-Patentliteratur**

- **Affinito, J. ; Hilliard, D.** A New Class of Ultra-Barrier Materials. *Proc. 47th Anspruch. Tech. Conf.,* April 2004, 563-593
- **O. Miesbauer ; M. Schmidt ; H.-C. Langowski.** Stofftransport durch Schichtsysteme aus Polymeren und dünnen anorganischen Schichten. *Vakuum in Forschung und Praxis,* 2008, vol. 20 (6), 32-40